# EUROPEAN PATENT SPECIFICATION

(11) **EP 3 190 477 B1**
(45) Date of publication and mention of the grant of the patent: **07.04.2021**
(21) Application number: 17150882.3
(22) Date of filing: 10.01.2017
(51) Int. Cl.: G06F 1/18, H05K 7/14

(54) **TOLERANCE COMPENSATING CIRCUIT BOARD LEVER**
TOLERANZAUSGLEICHENDER LEITERPLATTENHEBEL
LEVIER DE CARTE DE CIRCUIT AVEC COMPENSATION DE TOLÉRANCE

(30) Priority: 11.01.2016 US 201614992151
(43) Date of publication of application: 12.07.2017
(73) Proprietor: Hamilton Sundstrand Corporation, Charlotte, NC 28217 (US)
(72) Inventor: WAVERING, Jeffrey T., Rockford, IL Illinois 61109 (US); GAUVIN, Randy P., Beloit, WI Wisconsin 53511 (US)
(74) Representative: Dehns

(56) References cited:
- US-A- 5 139 430
- US-A1- 2003 172 523
- US-A1- 2005 136 715
- US-A1- 2010 265 679

## Description

### BACKGROUND OF THE INVENTION

This application relates to a structure and method for mounting circuit boards into a motherboard.

Modern systems are becoming more and more complex. Thus, complicated controls are incorporated into many systems. As an example, one such system could be on aerospace systems such as an aircraft.

A control module for such a system may include a chassis mounting a motherboard and a plurality of removable circuit boards. One type of circuit board, known as line removal modules, may provide a variety of functions.

Designers of the control modules will mount a motherboard and then select appropriate LRMs to provide the particular function demanded by the system which will utilize the control module. It is known that the removable LRMs must be held against the motherboard such that electronic connections are made.

In the past, levers have been utilized to lock the LRMs into the chassis and in contact with the motherboard. However, due to manufacturing tolerances, the known systems do not always provide sufficient LRM travel to ensure a reliable electrical connection. Also, various biasing arrangements have been proposed but are generally complex.

US 2010/265679 A1 discloses a control module in accordance with the preamble of claim 1.

US 5 139 430 A discloses a mechanical insertion/ejection device for use in mounting a printed circuit board into an electrical receptacle, US 2003/172523 A1 discloses a device for the insertion / extraction of a plug-in module into a module frame, and US 2005/136715 A1 discloses a lever-type assembly mountable onto a PC board or module.

### SUMMARY OF THE INVENTION

In accordance with the invention there is provided a control module as set forth in claim 1.

These and other features may be best understood from the following drawings and specification.

### BRIEF DESCRIPTION OF THE DRAWINGS

Figure 1A shows a control module.
Figure 1B schematically shows connection in the Figure 1A module.
Figure 2 shows a locking assembly in an unlocked position.
Figure 3A shows a locking assembly in a locked position.
Figure 3B shows a detail.
Figure 4 shows geometric details of the locking system.

### DETAILED DESCRIPTION

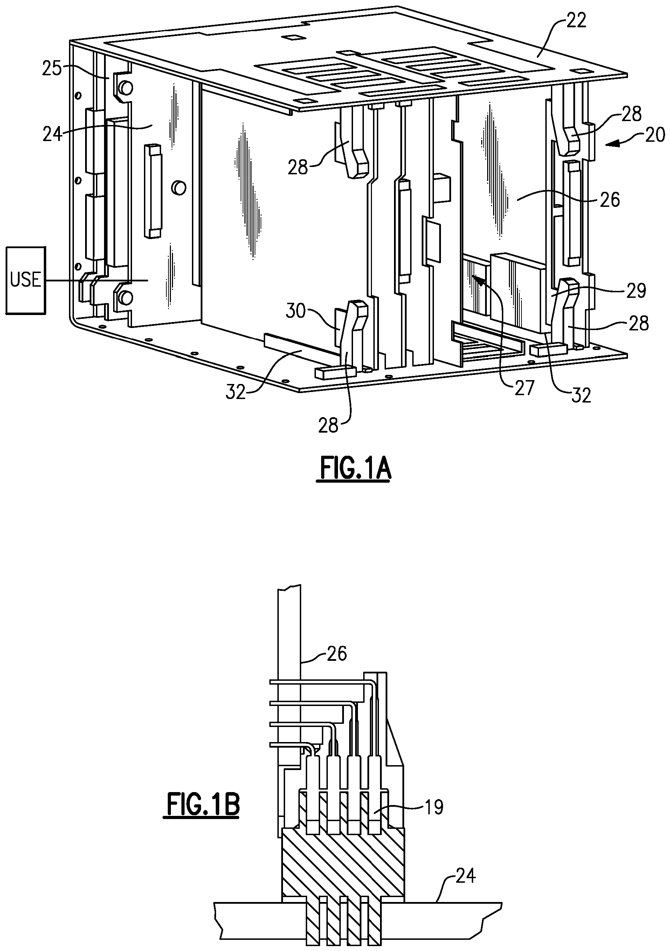

A control module 20 is illustrated in Figure 1A. The control module may have applications such as to provide controls for a system on an aircraft. An outer chassis 22 provides a housing that mounts a motherboard 24. The motherboard 24 is at an inner end 25, and the circuit boards extend towards an opening 27 from the motherboard 24. A plurality of line replaceable modules (LRMs) 26 are shown mounted to the motherboard. Any type of circuit board may be attached to the motherboard 24.

Motherboard 24 is shown communicating with a use, which may be an aircraft system. As known, module 20 provides control functions to the use. For example, the modules may be power distribution modules, power supply modules, communications modules, etc.

Levers 28 are used at opposed ends of the LRMs 26 remote from the motherboard 24. The levers 28 lock the LRMs within the chassis 22 and engaged to the motherboard 24. The LRMs 26 are generally planar and levers 28 are at both ends of the plane. A bracket 30 is fixed on a side of the LRMs 26 and the levers 28 are pivotally mounted on the brackets 30. A channel 32, attached to the chassis 22 is used to guide the LRM's into place within chassis 22 and to align LRM's 26 to their appropriate connector on motherboard 24..

As shown in Figure 1B, schematically, a motherboard 24 receives an electrical connection 19 from an LRM 26. Due to tolerance build-up, in the art, this connection has not always been fully mated to ensure a reliable electrical interface. A worker of ordinary skill would be able to calculate the tolerance build-up in any particular system.

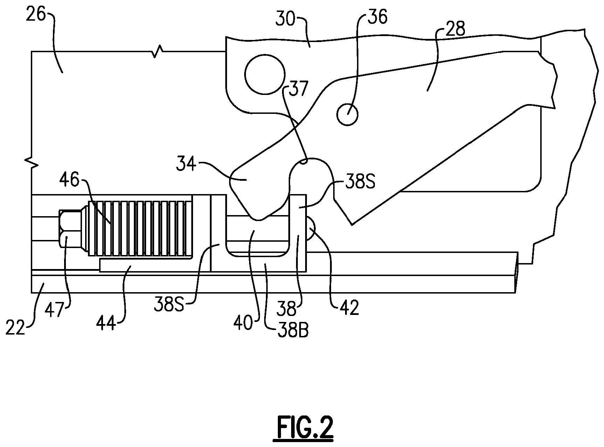

Figure 2 shows the locking assembly in an unlocked position. The lever 28 is pivoted outwardly away from a lock bracket 38. Lock bracket 38 is u-shaped, with sides 38S and a bottom 38B to define the u-shape.

As can be seen, a holder, such as a bolt or pin 40 extends through the sides 38S of lock bracket 38 and provides an abutment for a Belleville washer set or a spring of sufficient force 46 that is mounted in a fixed bracket 44. Fixed bracket 44 is L-shaped. A nut 47 on holder 40 provides a stop. The bracket 44 is fixed on the chassis 22 while the lock bracket 38 is slidable along the chassis 22. A head 42 of the holder 40 is on an opposed side of the bracket 38. A head 34 of the lever 28 is illustrated along with a pivot pin 36. A channel 37 is intermediate the pivot pin 36 and the head 34.

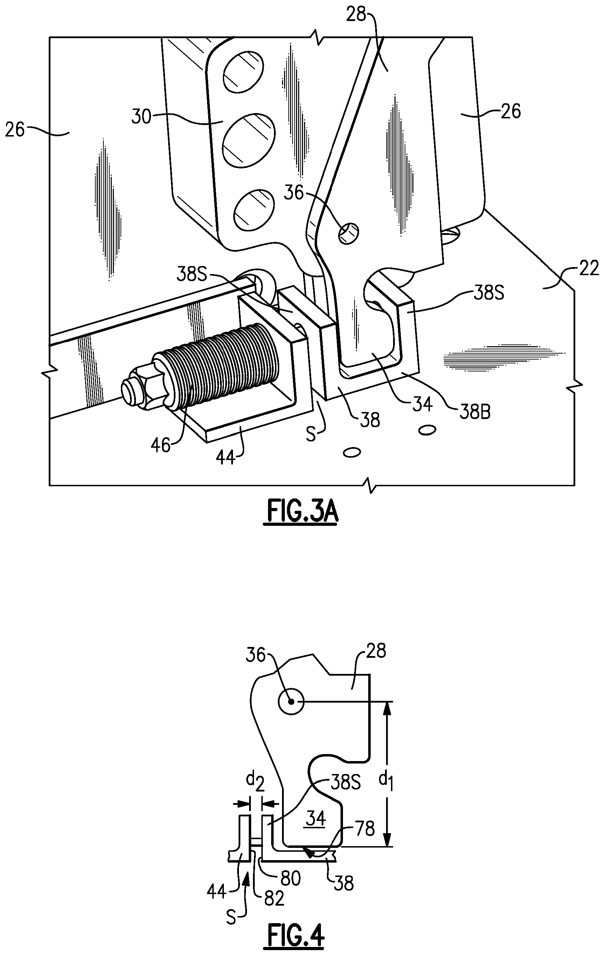

As shown in Figure 3A, the lever 28 has now been pivoted to a locked position. The head 34 cams against side wall 38S on the lock bracket 38 to move the lock bracket in an outward direction. As can be seen, there is a space S between the brackets 44 and 38. That is, when the lever 28 is moved to this position, it pulls the lock bracket 38 away from the fixed bracket 44, and against the bias force of the Belleville washers 46. When the lever 28 is in this position, the spring pushes the bracket 30 and hence the LRM 26 further into the chassis, such that the connection between the motherboard 24 and the LRM 26 is fully closed.

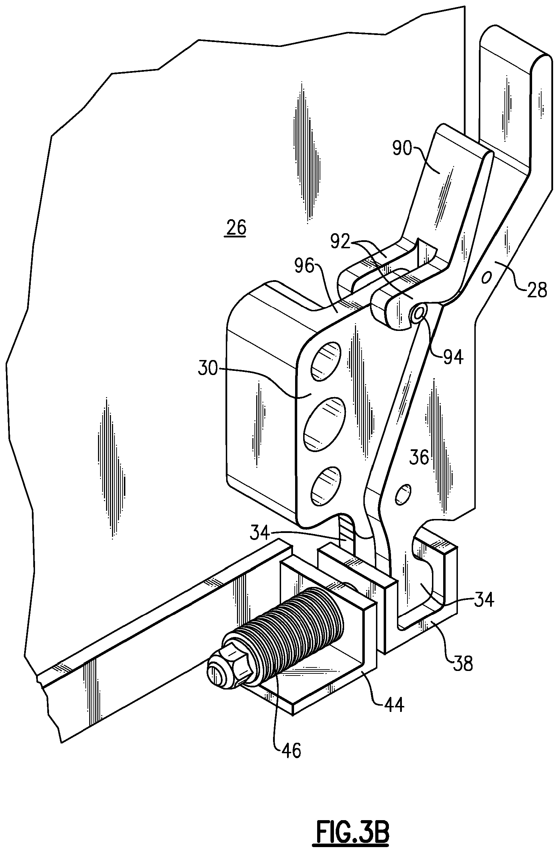

Figure 3B shows a locking pawl 90 which is pivotally connected to the lever 28. Pawl 90 has arms 92 that can be pivoted to the position illustrated where they lock on pins 94 on the bracket 30. The pawl 90 is moved to this position once the lever has been moved to the Figure 3A/3B position, and the pawl 90 locks the lever at that position.

To remove the LRM 26, the pawl 90 is pivoted away from the Figure 3B position, releasing the lever. As can also be seen, the lever 28 has heads 34 spaced about a central member 96 of the bracket 30. Thus, the pin 40 can extend between the spaced heads 34.

In a method of installing a circuit board into a motherboard according to this disclosure, a circuit board 26 is initially moved into the chassis 22, and moved toward the motherboard 24 for connection. During this movement, it may be necessary to slightly pivot the levers 28 such that the head 34 can move beyond an outer side 38S of the lock bracket 38 at both of the two locations.

Once the circuit board 26 is moved into the chassis sufficiently such that the head 34 of the lever 28 can be moved between the side walls 38S of the lock bracket 38, the levers 28 are then pivoted to the position such as shown in Figure 2.

Next, the levers 28 are pivoted such that the head 34 cams against the sides 38S on the lock brackets 38, and the levers are further pivoted, drawing the lock brackets 38 against the force from the spring 46 until it reaches the Figure 3A position. In this position, the Belleville washers 46, or other bias members, pull the lock brackets 38 back into the chassis, thus causing the levers 28 to further pull the circuit board 26 into the chassis, ensuring an adequate connection. The pawl 90 is then moved to the Figure 3B position.

As shown in Figure 4, a distance d₁ can be defined as between a center of the pivot point 36 and an end 78 on the head 34. A second distance d₂ is the distance across the gap S between the faces 82 and 80, respectively, of the brackets 44 and 38 ensures sufficient LRM movement to compensate for the tolerance accumulation of the system

In embodiments, d2 is a subset or partial part of the overall LRM travel that results from the d1 moment arm length and movement. The LRM 26 required overall movement or engagement travel will be vary depending on the mating connector types used between the LRM 26 and the motherboard, Item 24. Thus, d1 is selected to provide adequate LRM 26 movement to ensure a proper connection given the greatest possible tolerance stack-up for a given system.

In one feature, a chassis for a control module provides a housing having an inner end 25 and a forward opening 27. A fixed bracket 44 mounts a biasing member 46, and a lock bracket 38 slides on the housing. Lock bracket 38 is spaced towards the opening 27 from the fixed bracket 44. Biasing member 46 biases lock bracket 38 towards fixed bracket 44.

Although LRMs are disclosed, other circuit boards may come within the scope of this disclosure. In addition, while Belleville washers 46 are illustrated, other biasing members would come within the scope of this disclosure.

Although an embodiment of this invention has been disclosed, a worker of ordinary skill in this art would recognize that certain modifications would come within the scope of this invention. For that reason, the following claims should be studied to determine the true scope and content of this invention.

## Claims

1. A control module (20) comprising:
a motherboard (24); and
at least one circuit board (26) removably connected to said motherboard (24), and there being at least one lever (28) connected to said at least one circuit board (26), and said lever (28) being moveable between a release and a locked position, wherein said lever (28) contacts a lock bracket (38) in said locked position to move said lock bracket (38) against a spring force, such that a bias force maintains said at least one circuit board (26) in contact with said motherboard (24),
**characterised in that** said lever (28) is pivotally mounted on a bracket (30) on a side of said at least one circuit board (26), and has a pair of spaced heads (34) configured to cam against a side of said lock bracket (38) when said lever (28) is in said locked position.

2. The control module as set forth in claim 1, wherein said lock bracket (38) is configured to slide on a chassis (22) of said control module, as said lever (28) moves between said release and locked positions.

3. The control module as set forth in claim 1 or 2, wherein said lock bracket (38) is moveable relative to a fixed bracket (44) and said fixed bracket (44) mounts a biasing member (46) biasing said lock bracket (38) toward said motherboard (24), to provide said bias force.

4. The control module as set forth in claim 3, wherein said fixed bracket (44) receives a holder (40) for said biasing member (46) that extends through said lock bracket (38).

5. The control module as set forth in claim 3 or 4, wherein said biasing member includes Belleville washers.

6. The control module as set forth in any preceding claim, wherein said circuit board (26) is generally planar and extends between two ends and there being levers (28) and lock brackets (38) at each of said two ends.

7. The control module as set forth in any preceding claim, wherein said at least one circuit board (26) includes a plurality of removable circuit boards (26).

8. The control module set forth in any preceding claim, wherein a distance (d₁) between a center of a pivot point (36) on said lever (28) and an outer end (78) of a head (34) on said lever (28) is selected such that as said lever (28) is moved to said locked position a resultant overall travel of said circuit board (26) is adequate to ensure a proper connection given the greatest possible tolerance stack-up of the control module (20) of the mother board (24) and said at least one circuit board (26).

9. The control module as set forth in any preceding claim, wherein said at least one circuit board (26) is a line replaceable module.

## Patentansprüche

1. Steuermodul (20), umfassend:
eine Hauptplatine (24); und
mindestens eine Leiterplatte (26), die lösbar mit der Hauptplatine (24) verbunden ist, und wobei mindestens ein Hebel (28) vorliegt, der mit der mindestens einen Leiterplatte (26) verbunden ist, und der Hebel (28) zwischen einer Freigabe- und einer Verriegelungsposition beweglich ist, wobei der Hebel (28) in der Verriegelungsposition einen Sperrbügel (38) berührt, um den Sperrbügel (38) gegen eine Federkraft zu bewegen, sodass eine Vorspannkraft die mindestens eine Leiterplatte (26) in Kontakt mit der Hauptplatine (24) hält,
**dadurch gekennzeichnet, dass** der Hebel (28) schwenkbar an einer Halterung (30) an einer Seite der mindestens einen Leiterplatte (26) montiert ist, und ein Paar von beabstandeten Köpfen (34) aufweist, die konfiguriert sind, um gegen eine Seite des Sperrbügels (38) Nocken zu bilden, wenn sich der Hebel (28) in der Verriegelungsposition befindet.

2. Steuermodul nach Anspruch 1, wobei der Sperrbügel (38) konfiguriert ist, um auf einem Gehäuse (22) des Steuermoduls zu gleiten, wenn sich der Hebel (28) zwischen der Freigabe- und Verriegelungsposition bewegt.

3. Steuermodul nach Anspruch 1 oder 2, wobei der Sperrbügel (38) in Bezug auf eine feste Halterung (44) beweglich ist und durch die feste Halterung (44) ein Vorspannelement (46), das den Sperrbügel (38) vorspannt, an der Hauptplatine (24) montiert wird, um die Vorspannkraft bereitzustellen.

4. Steuermodul nach Anspruch 3, wobei die feste Halterung (44) einen Halter (40) für das Vorspannelement (46) aufnimmt, der sich durch den Sperrbügel (38) erstreckt.

5. Steuermodul nach Anspruch 3 oder 4, wobei das Vorspannelement Tellerfedern einschließt.

6. Steuermodul nach einem der vorhergehenden Ansprüche, wobei die Leiterplatte (26) im Allgemeinen flach ist und sich zwischen zwei Enden erstreckt und sich Hebel (28) und Sperrbügel (38) an jedem der zwei Enden befinden.

7. Steuermodul nach einem vorhergehenden Anspruch, wobei die mindestens eine Leiterplatte (26) eine Vielzahl von entfernbaren Leiterplatten (26) einschließt.

8. Steuermodul nach einem vorhergehenden Anspruch, wobei ein Abstand (d₁) zwischen einer Mitte eines Drehpunkts (36) an dem Hebel (28) und einem äußeren Ende (78) eines Kopfes (34) an dem Hebel (28) so ausgewählt ist, dass, wenn der Hebel (28) in die Verriegelungsposition bewegt wird, eine daraus resultierende Gesamtbewegung der Leiterplatte (26) geeignet ist, um eine korrekte Verbindung angesichts der größtmöglichen Toleranzsummierung des Steuermoduls (20) der Hauptplatine (24) und der mindestens einen Leiterplatte (26) zu gewährleisten.

9. Steuermodul nach einem vorhergehenden Anspruch, wobei die mindestens eine Leiterplatte (26) ein Line Replaceable Module ist.

## Revendications

1. Module de commande (20) comprenant :
une carte mère (24) ; et
au moins une carte de circuit (26) reliée de manière amovible à ladite carte mère (24), et il existe au moins un levier (28) relié à ladite au moins une carte de circuit (26), et ledit levier (28) étant mobile entre une position de déverrouillage et une position verrouillée, dans lequel ledit levier (28) entre en contact avec un support de verrouillage (38) dans ladite position verrouillée pour déplacer ledit support de verrouillage (38) contre une force de ressort, de sorte qu'une force de sollicitation maintient ladite au moins une carte de circuit (26) en contact avec ladite carte mère (24) ,
**caractérisé en ce que** ledit levier (28) est monté de manière pivotante sur un support (30) sur un côté de ladite au moins une carte de circuit (26), et a une paire de têtes (34) espacées conçues pour exercer une action de came contre un côté dudit support de verrouillage (38) lorsque ledit levier (28) est dans ladite position verrouillée.

2. Module de commande selon la revendication 1, dans lequel ledit support de verrouillage (38) est conçu pour coulisser sur un châssis (22) dudit module de commande, lorsque ledit levier (28) se déplace entre lesdites position de déverrouillage et position verrouillée.

3. Module de commande selon la revendication 1 ou 2, dans lequel ledit support de verrouillage (38) est mobile par rapport à un support fixe (44) et ledit support fixe (44) monte un élément de sollicitation (46) sollicitant ledit support de verrouillage (38) vers ladite carte mère (24), pour fournir ladite force de sollicitation.

4. Module de commande selon la revendication 3, dans lequel ledit support fixe (44) reçoit une fixation (40) pour ledit élément de sollicitation (46) qui traverse ledit support de verrouillage (38).

5. Module de commande selon la revendication 3 ou 4, dans lequel ledit élément de sollicitation comporte des rondelles de Belleville.

6. Module de commande selon une quelconque revendication précédente, dans lequel ladite carte de circuit (26) est généralement plane et s'étend entre deux extrémités et il existe des leviers (28) et des supports de verrouillage (38) à chacune desdites deux extrémités.

7. Module de commande selon une quelconque revendication précédente, dans lequel ladite au moins une carte de circuit (26) comporte une pluralité de cartes de circuit (26) amovibles.

8. Module de commande selon une quelconque revendication précédente, dans lequel une distance (d₁) entre un centre d'un point de pivot (36) sur ledit levier (28) et une extrémité extérieure (78) d'une tête (34) sur ledit levier (28) est sélectionnée de sorte que, lorsque ledit levier (28) est déplacé vers ladite position verrouillée, une course globale résultante de ladite carte de circuit (26) est adéquate pour assurer une laison correcte étant donné la plus grande accumulation de tolérance possible du module de commande (20) de la carte mère (24) et de ladite au moins une carte de circuit (26).

9. Module de commande selon une quelconque revendication précédente, dans lequel ladite au moins une carte de circuit (26) est un module de ligne remplaçable.
